# EUROPEAN PATENT SPECIFICATION

(11) **EP 1 976 114 B1**
(45) Date of publication and mention of the grant of the patent: **10.11.2010**
(21) Application number: 08102515.7
(22) Date of filing: 12.03.2008
(51) Int. Cl.: H03G 5/02, H03G 5/16, H04S 7/00

(54) **Automatic equalizer adjustment method**
Automatisches Verfahren zur Einstellung eines Entzerrers
Procédé d'ajustement automatique d'égalisateur

(30) Priority: 13.03.2007 TR 200701546
(43) Date of publication of application: 01.10.2008
(73) Proprietor: Vestel Elektronik Sanayi ve Ticaret A.S., 45030 Manisa (TR)
(72) Inventor: Yatir, Mustafa Nevzat, 45030 Manisa (TR); Bashan, Huseyin, 45030 Manisa (TR)
(74) Representative: Cayli, Hülya

(56) References cited:
- WO-A-2005/106843
- US-A- 5 040 220
- US-B1- 6 341 166

## Description

### Technical Field

The present invention relates to an automatic equalizer adjustment method, which is based on determinig the changes made in an equalizer mode according to user preferences, thereby automatically adjusting the remaining equalizer modes in a system wherein content-dependent automatic equalizer assignment is conducted by detecting the content information of an audio signal.

### Prior Art

The main purpose in altering the gain parameters of different frequency bands of an audio signal by means of using an equalizer is to change the tone of such an audio signal according to user preferences, thereby enhancing the user's enjoyment. Whilst the preference of a user usually remains the same or similar even for different audio signals, the variations on different audio signals' frequency bands are quite different. Because of this significant change, when a sound signal is changed, an equalizer adjusted by a user can not maintain the current sound tone. Many methods are being used to solve this problem.

The most widely used method to solve this problem is the use of a system having a plurality of equalizer modes. Thus, it becomes possible to rapidly switch between many user-predefined equalizer modes. When the equalizer modes are switched manually, however, it becomes necessary for a user to make a little time-taking adjustment, and to repeat this adjustment with a change in the audio signal. This circumstance diminishes the user's enjoyment. Said method can be made dynamic by making use of the sound type information present in the audio signal.

The most widely used method among known dynamic methods is activating the equalizer modes previously adjusted/assigned to individual sound types based on sound type information in audio signals, resulting in an automatic change in the equalizer mode in line with the current sound type information. Even though the adjustments to be made by the user during use is lessened to a certain extent, nevertheless all of the equalizer modes are to be checked by the user and adjusted previously. Therefore the user faces time loss during the installation of an audio system implementing such method.

Any such default equalizer modes assigned for individual sound type information in audio systems implementing the aforesaid dynamic method are redeterminable for new assignments to be made by the user. By this means it is aimed to reduce time loss experienced by users during the installation of the audio system. Even in this improved dynamic system, however, it may be necessary for the user to make adjustments in all equalizer modes.

Apart from said methods, various other methods have been developed that aim diminishing the influence of external factors on the sound tone within the sound propagation field. The basic purpose in such methods which are focused on automatically correcting the sound tone is to reduce sound distortions arising from external noise sources within the sound propagation field, or to change the equalizer adjustments according to frequency responses of sound sources within the audio system. Although such methods developed for preserving the sound tone aim to efficiently maintain the user enjoyment, no solutions are provided for adjustment-related problems encountered by users in equalizer modes during installation, since such installations will be based on the current equalizer adjustments.

In the document EP0729227, a vehicle speaker control system is disclosed. In the patent application US2005180578, a method and apparatus are described which ensure the adaptation of an audio signal to differing conditions of use.

Apart from these methods, another known method is focused on defining more than one user in audio systems to facilitate the use of such systems by more than one user. Once different users determine their own preferences, even when another user among such defined users starts using the audio system, there remains no need for him/her to make equalizer adjustments repeatedly. US 6 341 166 B1 discloses a method for adjusting equalization of audio signals.
In equalizer adjustment methods developed so far with more than one equalizer modes, the procedure of defining the user preferences in audio systems still takes substantial time, since the user preferences are entered individually for each equalizer mode adjustment.

Thanks to the method according to the present invention, the time required for adjusting the equalizer modes according to user preferences during installation is shortened as compared to the relevant techniques in the background art, and with the user having adjusted a single equalizer mode, all equalizer modes are automatically adjusted based on such user preference.

### Object of the Invention

The object of the method according to the present invention is to determine the change or changes made in an equalizer mode according to user preferences, thereby providing an automatic adjustment be made in other equalizer modes in a system wherein automatic equalizer assignment is made according to the content information of audio signals. Thus, user preferences defined by a user for a single equalizer mode are applied to other equalizer modes automatically, so that the necessity for the user to define his/her preferences for other equalizer modes is eliminated. Additionaly, since user preferences defined for an equalizer mode shall be efficiently transposed to other equalizer modes, the user satisfaction shall be enhanced in systems making use of the method according to the present invention.

### Description of Figures

The subject method is illustrated in annexed figures briefly described hereunder.
Figure 1 is a table displaying the audio signal content information and equalizer modes assigned according to user profiles.
Figure 2A is a table indicating the gain values in frequency bands of equalizer modes assigned by User 1.
Figure 2B is a table indicating the equalizer mode adjustment as a result of a change in an equalizer mode made according to a user preference.
Figure 2C is a table indicating the equalizer modes adjusted according to user preferences the gain values in the frequency bands of these modes, obtained by applying an adjustment made in an equalizer mode on other equalizer modes.
Figure 3 is a block diagram of a system wherein the subject method is applied.

### Description of Invention

The method according to the present invention determines the change(s) made in an equalizer mode according to user preferences, thereby providing an automatic adjustment be made in other equalizer modes in a system wherein automatic equalizer assignment is made according to the content information of audio signals.. Thus, user preferences defined by a user for a single equalizer mode are applied to other equalizer modes automatically, so that the necessity for the user to define his/her preferences for other equalizer modes is eliminated.

The subject method is used in systems wherein the equalizer mode is automatically changed in line with the content of an audio signal, as already being used in known techniques. In such systems, in which the equalizer mode to be switched to according to which audio signal content information to be determined is defined before or during use. This determination can both be performed by the user, and by the manufacturer of the system. Said equalizer modes and the gain values of frequency bands in these modes are re-determinable. In addition, in such systems more than one user can be defined. The audio signal content-dependant equalizer mode assignments of these users and/or their user preferences may be different.

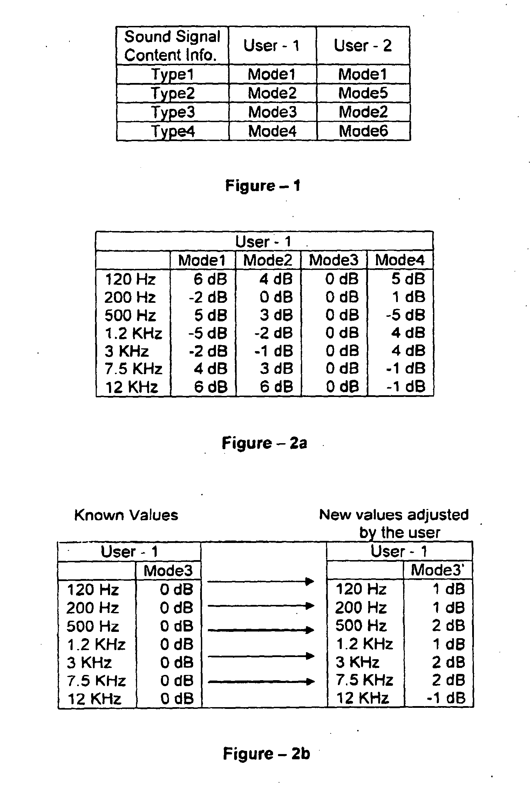

In a preferredembodiment, more than one user are present and said equalizer mode assignments are different for each user. In Figure 1 are illustrated the equalizer mode assignments adjusted by the users of this preferred system. In the equalizer bands the number (i.e. amount) of band, their frequency values or units and/or values may differ according to the systems employed.

As illustrated in Figure 1, User 1 made equalizer mode assignments Mode1, Mode2, Mode3, and Mode4, respectively, for the audio signal types with audio signal content information Type1, Type2, Type3, and Type4. The equalizer assignments made by User 2 are different from those of User 1.

The audio signal content information may comprise, but is not restricted to the audio signal type (AST), music genre, audio signal source, data other than sound information carried with the audio signal, values or data resulting from the analysis/calculations executed on the audio signal, and the combination thereof in various proportions. Information such as the audio signal type information, music genre information (e.g. POP, JAZZ, ROCK), and the source information of the audio signal are those parameters used to define an audio signal.

In Figure 2A, the frequency bands of equalizer modes assigned by User 1 and the corresponding gain values in these bands are shown. In Figure 2-A, it is aimed to provide the sound tone and/or quality desired by the user, by using such gain values in processing the audio signal.

In the preferredembodiment, any change made and entered by the user to reflect his/her preference on a previously-defined equalizer mode while listening to an audio signal is applied as it is entered in processing the present audio signal on the respective equalizer mode. Such a change is of a known type of equalizer adjustment and is conducted by changing the equalizer adjustments of an audio signal under processing in order to redefine the gain values in the related frequency values/ranges. (e.g. switching from bass +3 to bass +4). As illustrated in Figure 2B, due to the change made by the user according to his/her own preference on a previously-assigned equalizer mode, the user may obtain a desired level and/or quality of sound tone and confirm and/or save this change , and may prefer this changed processing operation be applied on future audio signal processes based on this saved equalizer mode. Said operation is the processing of the audio signal. In brief, it is simply to conduct a filtering according to the equalizer adjustments, or to change the gains of relevant frequency values/ranges or to change the equalizer mode assignments in line with the audio signal content. Such confirmation and/or saving operation may differ according to the processing method used in the system. Typically, this confirmation and/or saving operation can be realized by depressing a key (e.g. OK or ENTER key) reserved for this purpose. In other systems, if any such change is applied and not changed back for a certain period of time, it may be assumed a permanent one and may be saved automatically. By means of this change, the user makes his/her sound tone and/or equalizer mode preference only once in the processing of audio signal.

The detecting operation may be performed by comparing the gain values of an equalizer mode on which a change is made, to the gain values in the respective equalizer mode provided by default for the relevant signal type, or by storing on a memory any changes made during a changing operation. For instance, artificial neural networks may be used in generating such a function. In addition, any value change in an equalizer mode on which a change is made can be transposed to other equalizer modes in a one-to-one fashion. Or for transposing purposes, operations to be performed to switch from an equalizer mode on which a change is made to other equalizer modes may be defined on a table. Various methods can be found for such transposing operations.

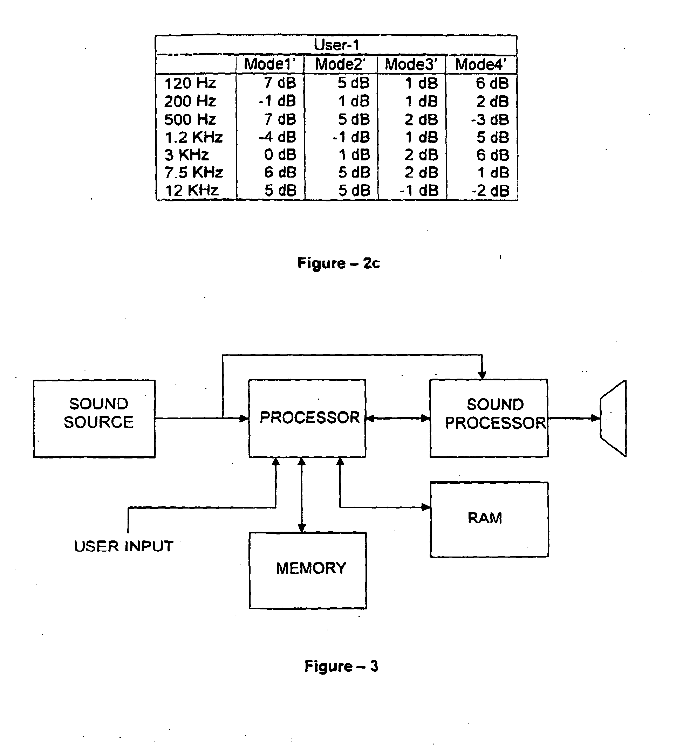

With the user confirming and/or saving a change reflecting his/her preference, the user preference is detected by the system and is applied on other unchanged modes, as illustrated in Figure 2C, by means of any of the methods referred to above, or by means of a mathematical formula. A one-to-one transposing is shown in Figure 2C. Thus, the user is freed from additional equalizer adjustment and saving operations to be performed on other equalizer modes for the sound tone and/or sound quality he/she desires. Additionally, since it would be difficult for some users to apply his/her preferences on all equalizer modes and to manually change each equalizer mode among them, such systems are provided with an ease of use and installation.

Such a transposing operation may differ with the configuration of systems in which the subject method is used.

The transposing approaches according to the subject method comprise, but is not restricted to the following exemplary applications:
- Transposing any change made in an equalizer mode to other equalizer modes (e.g. if the treble gain value is increased by 2 in an equalizer mode, the treble gain values of other equalizer modes are augmented by 2 as well).
- Transposing any change made in an equalizer mode to other equalizer modes by a ratio difference as compared to the value before such change was made (e.g. if the treble gain value of an equalizer mode is increased by 20% as compared to the value present right before such adjustment, the treble gain values of other equalizer modes are augmented by 20% as well). (Said change per cent may both be the proportion of the value preceding the instant change to the value following the instant change, and be a proportion of a default value maintained in a memory to the value following the instant change).
- Entering a value obtained by means of detecting a change made in an equalizer mode as a variable into a function that is previously defined and stored on a nonvolatile memory, and transposing the resulting value from such function on other equalizer modes in the form of a change (said function can have the structure of functions used in filtering processes).
- Using an artificial neural network in the process of transposing any change made in an equalizer mode to other equalizer modes. Said artificial neural network generates a function depending on the change made by the user, and the current change value is • applied as a variable to this function so that the values to be transposed to other equalizer modes are determined.
- Using a table while transposing a change made in an equalizer mode to other equalizer modes, said table defining the operations to be made on other equalizer modes in correspondence to such change. (e.g., if bas is adjusted to +5 in Equalizer Mode1, the bas is adjusted to 3 in the Equalizer Mode3).
- Another method that can be used in transposing a change made in an equalizer mode to other equalizer modes is based on automatically tracing the user operations (equalizer adjustments, volume adjustments, etc.) and determining the user preferences, and making use of such resulting user preference-dependant values in adjusting other equalizer modes by means of an artificial neural network or a constant function.
- A further method -which resembles, but is different from the one-to-one transposing of any change made by the user in an equalizer mode to other equalizer modes- can be used, in which a equalizer/filter block is added for varying frequency value/range gain values according to a change made by the user before and/or after the equalizer mode operation level. The user may perform changes on this equalizer/filter block only. Different equalizer/filter blocks can be defined for each user. These equalizer/filter blocks can be selected according to user preferences.

The method according to the present invention comprises mainly the following steps:
- determining the audio signal content information in the audio signal,
- determining the equalizer mode and the values of this mode within the relevant frequency values/ranges to be used in sound processing based on the determined audio signal content information and on the present user information and/or preferences,
- incorporating any change made in an equalizer mode by the user into the sound processing operation,
- saving the equalizer mode on which such change is made, if the user or system confirms and/or saves any such change,
- determining the user preference/preferences by evaluating the change made by the user,
- automatically applying any such determined user preferences to other equalizer modes and saving the changes made for such equalizer modes.

Some differences may be seen in the steps given above, according to the system in which the subject method is to be used. Typical differences probably to be encountered comprise, but is not restricted to the followings:
- the type of the audio signal content information and the determination method thereof,
- the number of users and equalizer modes defined in the system,
- the number of equalizer bands,
- the use or nonuse of a test signal in determining the user preferences,
- the assigning procedure of equalizer modes,
- the changes performable on the equalizer mode by the user,
- evaluating process of such changes,
- operations executed for the changes to be made automatically on other equalizer modes,
- operations to be executed for maximum and minimum value-related problems possible to emerge during the automatic adjustment process of the gains of frequency value/ranges equalizer modes.

The block diagram of a preferred system making use of the subject method is illustrated in Figure 3. According to this illustration, said preferred system comprises an audio signal source; a sound processor whereon the audio signals are processed; a user interface allowing the users to enter their preferences and to change the current equalizer modes or equalizer assignments; a nonvolatile memory whereon any data maintained within the system is saved and stored; RAM to provide dynamicity for processes and to improve the system's usability; sound output (speaker) to output any processed audio signal; and a microprocessor executing all processes within the system except sound processing, including the determination of an audio signal's content information, of user preferences, making/assigning/selecting equalizer adjustments, storing on the RAM any unsaved data or the data used by processes under execution. The systems whereon the subject method is applied may differ among themselves. The microprocessor and the sound processor, for instance, may be in an integrated form in some systems.

Any data required to apply the user preferences, equalizer modes and the method are stored on a nonvolatile memory.

A volatile memory (e.g. RAM) is used to execute any temporary changes be applied in time of such changes and to avoid the user preferences kept in the nonvolatile memory from becoming affected with temporary changes.

By means of the method according to the present invention, any desired or ideal sound tone and/or quality is obtained for any type of audio signal by enabling the users providing minimum data input to sound systems to reflect their preferences. Thus, the time required for a user to define his/her preferences in the system is shortened and the user preference is applied to each and any equalizer modes in an efficient manner.

In addition to applying the method according to the present invention, it may be feasible in such systems to maximally reach the desirable sound tone and/or quality and so to enhance the user enjoyment further, by taking into account the frequency response characteristics of speakers within the system, the noise present in the sound propagation field, the frequency response characteristics of the sound propagation field.

## Claims

1. A method performing automatic equalizer adjustment according to the content information in an audio signal, comprising the steps of
• determining the audio signal content information in the audio signal,
• determining an equalizer mode and the gain values of this mode within the relevant frequency values/ranges to be used in sound processing based on_the audio signal content information and/or on the current user information and/or preferences,
• providing the user with the option of changing the gain values of the current equalizer modes,
said method being **characterized in that**;
any change or changes made in the gain value of the current equalizer mode is determined and applied correspondingly to the gain values of all other equalizer modes, so that other equalizer modes are adjusted automatically.

2. A method according to Claim 1, wherein any such user preference to detected once the change is confirmed and/or saved by the user.

3. A method according to Claim 1, wherein any such change made on said equalizer modes is a change made in the gain values of the frequency bands of equalizer modes.

4. A method according to Claim 1, wherein any such change made on said equalizer modes is a change made in the equalizer mode assignments to be processed in line with the audio signal's content information.

5. A method according to Claim 1, wherein the content information in said audio signals includes, but is not restricted to the followings: audio signal type, music genre, audio signal source, data other than sound information carried with the audio signal, values or data obtained from the analysis/calculations executed on the audio signal, and the combinationor ratio thereof.

6. A method according to Claim 1, wherein any such change made is applied as of the moment this change is made in processing the current audio signal in the respective equalizer mode.

7. A method according to Claim 1, wherein more than one user can be defined.

8. A method according to Claim 1, wherein any such change made on an equalizer mode is transposed to other equalizer modes in a one-to-one manner.

9. A method according to Claims 1 or 8, wherein any such change made on an equalizer mode is transposed to other equalizer modes by a ratio difference as compared to the value before such change was made.

10. A method according to Claim 1, wherein a value obtained by means of detecting any change made in an equalizer mode is entered as a variable into a mathematical function that is previously defined and stored on a nonvolatile memory, and the resulting value from such mathematical function is transposed to other equalizer modes in the form of a change.

11. A method according to Claims 8 or 9, wherein a table is used while transposing a change made in an equalizer mode to other equalizer modes, said table defining the operations to be made on other equalizer modes in correspondence to such change.

12. A method according to Claims 8. 9 or 11, wherein an artificial neural network is used in the process of transposing any change made in an equalizer mode to other equalizer modes, wherein said artificial neural network generates a function according to such change made by the user, and the current change value is applied as a variable to this function so that the values to be transposed to other equalizer modes are determined.

13. A method according to Claims 8, 9. 11 or 12, wherein the transposing of a change made in an equalizer mode to other equalizer modes is based on tracing the user operations (equalizer adjustments, volume adjustments, etc.) and determining the user preferences automatically by the system, and making use of such resulting user preference-dependant values in adjusting other equalizer modes by means of an artificial neural network or a constant function.

14. A method according to Claim 11, wherein said mathematical function is previously determined.

15. A method according to Claim 14, wherein said constant function is previously determined.

16. A method according to Claim 1, wherein at least one additional equalizer/filter block is provided, in which the gain values of the frequency value/range are changed according to any change made by the user, before and/or after the equalizer mode processing equalizer/filter block.

17. A method according to Claim 16, wherein the user make changes only on the additional_equalizer/filter block.

18. A method according to Claim 17, wherein different equalizer/filter blocks are defined for each user.

19. A method according to Claim 1, wherein any data required to apply the user preferences, equalizer modes and the method are stored on a nonvolatile memory.

20. A method according to Claim 1, wherein a volatile memory (e.g. RAM) is used to execute any temporary changes be applied in time of such changes and to avoid the user preferences kept in the nonvolatile memory from becoming affected with temporary changes.

21. A method according to Claim 1 for use in systems processing audio signals.

## Patentansprüche

1. Verfahren zum Durchführen einer automatischer Entzerrereinstellung entsprechend dem Informationsgehalt in einem Audiosignal, folgende Schritte umfassend:
• Bestimmen des Audiosignalinformationsgehalts im Audiosignal,
• Bestimmen einer Entzerrerbetriebsart und der Verstärkungswerte dieser Betriebsart innerhalb der in der Tonverarbeitung zu verwendenden relevanten Frequenzwerte/-bereiche auf Grundlage des Audiosignalinformationsgehalts und/oder der aktuellen Benutzerinformationen und/oder Benutzerpräferenzen,
• Bereitstellen der Option an den Benutzer, die Verstärkungswerte der aktuellen Entzerrerbetriebsarten zu verändern,
wobei das Verfahren **dadurch gekennzeichnet ist, dass**:
jede Veränderung oder Veränderungen, die an den Verstärkungswerten der aktuellen Entzerrerbetriebsart vorgenommen wird bzw. werden, entsprechend den Verstärkungswerten aller anderen Entzerrerbetriebsarten bestimmt und
auf diese angewendet wird bzw. werden, so dass auch andere Entzerrerbetriebsarten automatisch eingestellt werden.

2. Verfahren nach Anspruch 1, wobei jede derartige Benutzerpräferenz erfasst wird, sobald die Veränderung vom Benutzer bestätigt und/oder gespeichert wird.

3. Verfahren nach Anspruch 1, wobei jede derartige, an den Entzerrerbetriebsarten vorgenommene Veränderung eine Veränderung ist, die an den Verstärkungswerten der Frequenzbänder der Entzerrerbetriebsarten vorgenommen wird.

4. Verfahren nach Anspruch 1, wobei jede derartige, an den Entzerrerbetriebsarten vorgenommene Veränderung eine Veränderung ist, die an den Entzerrerbetriebsartzuordnungen vorgenommen wird, die zusammen mit dem Audiosignalinformationsgehalt zu verarbeiten sind.

5. Verfahren nach Anspruch 1, wobei der Informationsgehalt in den Audiosignalen Folgendes enthält, aber nicht darauf beschränkt ist: Audiosignaltyp, Musikgenre, Audiosignaiquelle, andere Daten als die mit dem Audiosignal transponierte Toninformation, Werte oder Daten, die aus der Analyse/den Berechnungen erhalten werden, die am Audiosignal durchgeführt werden, und die Kombination oder das Verhältnis von diesen.

6. Verfahren nach Anspruch 1, wobei jede derartige vorgenommene Veränderung ab dem Moment, ab dem die Veränderung vorgenommen wird, in der Verarbeitung des aktuellen Audiosignals in der jeweiligen Entzerrerbetriebsart angewendet wird.

7. Verfahren nach Anspruch 1, wobei mehr als ein Benutzer definiert werden kann.

8. Verfahren nach Anspruch 1, wobei jede derartige, an einer Entzerrerbetriebsart vorgenommene Veränderung, Eins zu Eins auf andere Entzerrerbetriebsarten transponiert wird.

9. Verfahren nach Anspruch 1 oder 8, wobei jede derartige, an einer Entzerrerbetriebsart vorgenommene Veränderung mit einer Verhältnisdifferenz im Vergleich zu dem Wert, bevor eine derartige Veränderung erfolgte, auf andere Entzerrerbetriebsarten transponiert wird.

10. Verfahren nach Anspruch 1, wobei ein Wert, der durch Erfassung jeder an einer Entzerrerbetriebsart vorgenommenen Veränderung erhalten wird, als Variable in eine mathematische Funktion einfließt, die vorab definiert und in einem nichtflüchtigen Speicher gespeichert wird, und der sich aus einer derartigen mathematischen Funktion ergebende Wert in Form einer Veränderung auf andere Entzerrerbetriebsarten transponiert wird.

11. Verfahren nach Anspruch 8 oder 9, wobei beim Transponieren einer an einer Entzerrerbetriebsart vorgenommenen Veränderung auf andere Entzerrbetriebsarten eine Tabelle verwendet wird, die die Operationen definiert, die an anderen Entzerrerbetriebsarten in Übereinstimmung mit einer derartigen Veränderung vorgenommen werden sollen.

12. Verfahren nach den Ansprüchen 8, 9 oder 11, wobei ein künstliches neuronales Netz in dem Prozess des Transponierens jeder an einer Entzerrerbetriebsart vorgenommenen Änderung auf andere Entzerrerbetriebsarten verwendet wird, wobei das künstliche neuronale Netz eine Funktion entsprechend einer derartigen, vom Benutzer vorgenommenen Veränderung generiert, und der aktuelle Veränderungswert als Variable auf diese Funktion angewendet wird, so dass die Werte bestimmt werden, die auf andere Entzerrerbetriebsarten transponiert werden sollen.

13. Verfahren nach den Ansprüchen 8, 9, 11 oder 12, wobei das Transponieren einer an einer Entzerrerbetriebsart vorgenommenen Veränderung auf andere Entzerrerbetriebsarten auf einer Rückverfolgung der Benutzeroperationen (Entzerrereinstellungen, Lautstärkeeinstellungen, etc.) und automatischen Bestimmung der Benutzerpräferenzen durch das System und der Nutzung von derartigen sich ergebenden benutzerpraferenzabhängigen Werten bei der Einstellung anderer Entzerrerbetriebsarten mittels eines künstliche neuronalen Netzes oder einer konstanten Funktion beruht.

14. Verfahren nach Anspruch 11, wobei die mathematische Funktion vorab bestimmt wird.

15. Verfahren nach Anspruch 14, wobei die konstante Funktion vorab bestimmt wird.

16. Verfahren nach Anspruch 1, wobei mindestens ein zusätzlicher Entzerrer-/Filterblock vorgesehen ist, in dem die Verstärkungswerte des Frequenzwerts/- bereichs entsprechend jeder durch den Benutzer am Entzerrer-/Filterblock vorgenommenen Veränderung vor und/oder nach der Entzerrerbetriebsartverarbeitung verändert werden.

17. Verfahren nach Anspruch 16, wobei der Benutzer Veränderungen nur am zusätzlichen Entzerrer-/Filterblock vornimmt.

18. Verfahren nach Anspruch 17, wobei für jeden Benutzer verschiedene Entzerrer-/Filterblöcke definiert sind.

19. Verfahren nach Anspruch 1, wobei alle Daten, die erforderlich sind, um die Benutzerpräferenzen, die Entzerrerbetriebsarten und das Verfahren anzuwenden, in einem nichtflüchtigen Speicher gespeichert sind.

20. Verfahren nach Anspruch 1, wobei ein flüchtiger Speicher (z.B. RAM) verwendet wird, um alle temporären Veränderungen auszuführen, die zur Zeit derartiger Veränderungen anzuwenden sind, und um zu verhindern, dass die Benutzerpräferenzen, die im nichtflüchtigen Speicher gespeichert sind, von derartigen temporären Veränderungen beeinflusst werden.

21. Verfahren nach Anspruch 1 zum Einsatz in Systemen, die Audiosignale verarbeiten.

## Revendications

1. Procédé d'exécution d'ajustement automatique d'égaliseur en fonction des informations de contenu dans un signal audio, comprenant les étapes consistant à :
. déterminer les informations de contenu de signal audio dans le signal audio,
. déterminer un mode d'égaliseur et les valeurs de gain de ce mode dans les limites des valeurs/plages de fréquence pertinentes à utiliser dans un traitement du son sur la base des informations de contenu de signal audio et/ou des informations et/ou des préférences actuelles de l'utilisateur,
. fournir à l'utilisateur l'option de modifier les valeurs de gain des modes actuels d'égaliseur,
ledit procédé étant **caractérisé en ce que :**
toute modification ou toutes modifications effectuées dans les valeurs de gain du mode actuel d'égaliseur sont déterminées et appliquées de manière correspondante aux valeurs de gain de tous les autres modes d'égaliseur, de sorte que les autres modes d'égaliseur sont ajustés automatiquement.

2. Procédé selon la revendication 1, dans lequel toute telle préférence d'utilisateur est détectée une fois que la modification a été confirmée et/ou sauvegardée par l'utilisateur.

3. Procédé selon la revendication 1, dans lequel toute telle modification effectuée sur lesdits modes d'égaliseur est une modification effectuée dans les valeurs de gain des bandes de fréquence des modes d'égaliseur.

4. Procédé selon la revendication 1, dans lequel toute telle modification effectuée sur lesdits modes d'égaliseur est une modification effectuée dans les attributions de mode d'égaliseur à traiter en correspondance avec les informations de contenu du signal audio.

5. Procédé selon la revendication 1, dans lequel les informations de contenu dans lesdits signaux audio comprennent, mais sans y être limitées : le type de signal audio, le genre de musique, la source du signal audio, des données autres que les informations de son transportées avec le signal audio, des valeurs ou des données obtenues par l'analyse/les calculs effectués sur le signal audio et la combinaison ou le rapport de ceux-ci.

6. Procédé selon la revendication 1, dans lequel toute telle modification effectuée est appliquée à partir du moment auquel cette modification est effectuée lors du traitement du signal audio actuel dans le mode d'égaliseur respectif.

7. Procédé selon la revendication 1, dans lequel plusieurs utilisateurs peuvent être définis.

8. Procédé selon la revendication 1, dans lequel toute telle modification effectuée sur un mode d'égaliseur est transposée aux autres modes d'égaliseur d'une manière biunivoque.

9. Procédé selon les revendications 1 ou 8, dans lequel toute telle modification effectuée sur un mode d'égaliseur est transposée aux autres modes d'égaliseur par une différence de rapport comparé à la valeur avant que cette modification ne soit effectuée.

10. Procédé selon la revendication 1, dans lequel une valeur obtenue au moyen de la détection de toute modification effectuée dans un mode d'égaliseur est entrée en tant que variable dans une fonction mathématique qui est définie au préalable et mémorisée dans une mémoire non volatile, et la valeur résultante de cette fonction mathématique est transposée aux autres modes d'égaliseur sous la forme d'une modification.

11. Procédé selon les revendications 8 ou 9, dans lequel une table est utilisée pendant la transposition d'une modification effectuée dans un mode d'égaliseur aux autres modes d'égaliseur, ladite table définissant les opérations à effectuer sur les autres modes d'égaliseur en correspondance avec cette modification.

12. Procédé selon les revendications 8, 9 ou 11, dans lequel un réseau neuronal artificiel est utilisé dans le processus de transposition de toute modification effectuée dans un mode d'égaliseur aux autres modes d'égaliseur, dans lequel ledit réseau neuronal artificiel génère une fonction conformément à cette modification effectuée par l'utilisateur, et la valeur de modification actuelle est appliquée en tant que variable à cette fonction de sorte que les valeurs à transposer aux autres modes d'égaliseur soient déterminées.

13. Procédé selon les revendications 8, 9, 11 ou 12, dans lequel la transposition d'une modification effectuée dans un mode d'égaliseur aux autres modes d'égaliseur est basée sur le suivi des opérations d'utilisateur (ajustements d'égaliseur, ajustements de volume, etc.) et la détermination des préférences d'utilisateur automatiquement par le système, et l'utilisation de ces valeurs dépendant des préférences d'utilisateur résultantes lors de l'ajustement des autres modes d'égaliseur au moyen d'un réseau neuronal artificiel ou d'une fonction constante.

14. Procédé selon la revendication 11, dans lequel ladite fonction mathématique est déterminée au préalable.

15. Procédé selon la revendication 14, dans lequel ladite fonction constante est déterminée au préalable.

16. Procédé selon la revendication 1, dans lequel au moins un bloc d'égaliseur/filtre supplémentaire est prévu, dans lequel les valeurs de gain de la valeur/plage de fréquence sont modifiées conformément à toute modification effectuée par l'utilisateur, avant et/ou après le bloc d'égaliseur/filtre de traitement de mode d'égaliseur.

17. Procédé selon la revendication 16, dans lequel l'utilisateur effectue des modifications uniquement sur le bloc d'égaliseur/filtre supplémentaire.

18. Procédé selon la revendication 17, dans lequel différents blocs d'égaliseur/filtre sont définis pour chaque utilisateur.

19. Procédé selon la revendication 1, dans lequel toutes données nécessaires pour appliquer les préférences d'utilisateur, les modes d'égaliseur et le procédé sont mémorisés dans une mémoire non volatile.

20. Procédé selon la revendication 1, dans lequel une mémoire volatile (par exemple, une RAM) est utilisée pour que toutes modifications temporaires soient appliquées au moment de ces modifications et pour éviter que les préférences d'utilisateur contenues dans la mémoire non volatile ne soient affectées par des modifications temporaires.

21. Procédé selon la revendication 1 destiné à être utilisé dans des systèmes traitant des signaux audio.
